# EUROPEAN PATENT APPLICATION

(11) **EP 4 627 965 A1**
(43) Date of publication of application: **08.10.2025**
(21) Application number: 25168565.7
(22) Date of filing: 04.04.2025
(51) Int. Cl.: A45C 11/00, E05D 11/08, G06F 1/16, E05D 11/00, A45C 13/00, E05D 3/12

(54) **PROTECTIVE ENCLOSURE**

(30) Priority: 04.04.2024 SE 2430183
(71) Applicant: Topgolf Sweden AB, 182 33 Danderyd (SE)
(72) Inventor: Bodin, Johan, 121 37 Johanneshov (SE); Fredander, Bo, 197 36 Bro (SE); Gallon, Anders, 126 47 Hägersten (SE)
(74) Representative: Noréns Patentbyrå AB

(57) **Abstract**

An enclosure includes a base shell, a lid and at least one hinge coupled between the lid and the base shell to enable relative pivoting thereof between open and closed states. The base shell has a face edge extending forward of a rear wall to define a top side, a bottom side, a left side and a right side. The lid has a front cover and first and second side walls. An interface of the hinge is within a space defined by the face edge, the rear wall, the top side, the bottom side, the left side and the right side of the base shell.

## Description

### BACKGROUND

The present invention relates generally to the field of electronic display technologies, and more specifically, to an improved method and apparatus for protecting outdoor electronic display screens from environmental factors.

In recent years, the deployment of electronic display screens in outdoor environments has become increasingly common. These displays are used in a variety of applications, including but not limited to advertising, information dissemination, and entertainment. Despite their widespread usage, outdoor electronic display screens face significant challenges due to exposure to harsh environmental conditions. Rain, snow, dust, and corrosive atmospheres can severely damage these displays or significantly shorten their operational life cycle. The implications of such damage are manifold, ranging from diminished visual quality and functionality to increased maintenance costs and reduced reliability.

Several solutions have been proposed and implemented to mitigate the adverse effects of environmental exposure on outdoor electronic display screens. A common approach involves housing the display screen within a protective enclosure. These enclosures are designed to shield the screens from direct exposure to environmental factors. However, existing solutions have significant drawbacks. For instance, placing the display screen inside a larger box can make the overall installation cumbersome and aesthetically unpleasing. Furthermore, the use of bulky, external hinges for access and maintenance introduces additional points of failure. These hinges, being exposed to the same environmental conditions as the display screens, are susceptible to corrosion, wear, and tear, thereby compromising the functionality and durability of the protective solution.

Thus, there exists a need for an innovative approach to protect outdoor electronic display screens that addresses the limitations of current protective measures, without compromising the display's aesthetics, functionality, or durability.

### SUMMARY

In one aspect, an enclosure for a display screen is provided. The enclosure comprises: a base shell having a face edge extending forward of a rear wall to define a top side, a bottom side, a left side and a right side;
a lid having a front cover and first and second side walls; and
at least one hinge coupled between the lid and the base shell to enable relative pivoting thereof between open and closed states such that an interface of the hinge is within a space defined by the face edge, the rear wall, the top side, the bottom side, the left side and the right side of the base shell.

Various embodiments can include one or more of the following features. The hinge can offer a torque resisting relative pivoting of the lid and base shell. The hinge, rather than geometry of the lid and/or base shell, can limit a range of relative pivoting between the lid and the base shell in at least one direction. A bezel can be provided to the face edge of the base shell. The at least one hinge can include a first hinge coupled between an interior surface of the rear wall of the base shell and an interior surface of the first side wall of the lid and a second hinge coupled between the interior surface of the rear wall of the base shell and an interior surface of the second side wall of the lid. The at least one hinge can include a knuckle coupled to the base shell through a leaf and a shaft rotatable within the knuckle and coupled to the lid.

The lid can be fixedly mounted to the shaft. A gasket surrounding the shaft can be provided. Relative pivoting between the lid and the base shell can be limited by a tab mounted to the shaft and a stationary stop mounted to the base shell. The shaft can extend through an opening in the one of the left side and right side of the base shell.

In another aspect, a protective enclosure is provided. The enclosure comprises:
a base shell having a face edge extending forward of a rear wall to define a top side, a bottom side, a left side and a right side;
a lid having a front cover and first and second side walls; and
at least one hinge configured for coupling between the lid and the base shell to enable relative pivoting thereof between open and closed states such that an interface of the hinge is within a space defined by the face edge, the rear wall, the top side, the bottom side, the left side and the right side of the base shell.

Various embodiments can include one or more of the following features. The hinge can be configured to offer a torque resisting relative pivoting of the lid and base shell. The hinge, rather than geometry of the lid and/or base shell, can be configured to limit a range of relative pivoting between the lid and the base shell in at least one direction. A bezel can be configured for mating with the face edge of the base shell. The at least one hinge can include a first hinge configured for coupling between an interior surface of the rear wall of the base shell and an interior surface of the first side wall of the lid and a second hinge configured for coupling between the interior surface of the rear wall of the base shell and an interior surface of the second side wall of the lid.

The at least one hinge can include a knuckle configured for coupling to the base shell through a leaf; and a shaft rotatable within the knuckle and configured for coupling to the lid. The shaft can be coupled to the first side wall of the lid.

The lid can be configured for fixed mounting to the shaft. A gasket can surround the shaft. A tab mounted to the shaft and a stationary stop mounted to the base shell can be configured to limit relative pivoting between the lid and the base shell. The shaft can be configured to extend through an opening in the one of the left side and right side of the base shell.

### BRIEF DESCRIPTION OF THE DRAWINGS

The summary above, as well as the following detailed description of illustrative embodiments, is better understood when read in conjunction with the appended drawings. For the purpose of illustrating the disclosure, example constructions of the disclosure are shown in the drawings. However, the disclosure is not limited to specific methods and instrumentalities disclosed herein. Moreover, those in the art will understand that the drawings are not to scale. Wherever possible, like elements have been indicated by identical numbers.

Embodiments of the disclosure will now be described, by way of example only, with reference to the following diagrams wherein:
FIG. 1 illustrates a perspective view of an enclosure, in accordance with some embodiments.
FIG. 2 illustrates a front view of the enclosure, in accordance with some embodiments.
FIG. 3 illustrates a rear view of the enclosure, in accordance with some embodiments.
FIG. 4 illustrates a top view of the enclosure, in accordance with some embodiments.
FIG. 5 illustrates a bottom view of the enclosure, in accordance with some embodiments.
FIG. 6 illustrates a left side view of the enclosure, in accordance with some embodiments.
FIG. 7 illustrates a perspective view of the enclosure in an intermediate state, in accordance with some embodiments.
FIG. 8 illustrates a perspective view of the enclosure in a completely closed state, in accordance with some embodiments.
FIG. 9 illustrates a detail view of a hinge suitable for use in association with disclosed enclosures, in accordance with some embodiments.
FIG. 10 illustrates a side view of the hinge of FIG. 9 in isolation, in accordance with some embodiments.
FIG. 11 illustrates a perspective view of the enclosure with a display screen provided thereto, in accordance with some embodiments.
FIG. 12 illustrates a perspective view of the enclosure with a bezel provided thereto, in accordance with some embodiments.

### DETAILED DESCRIPTION

The following detailed description illustrates embodiments of the disclosure and manners by which they can be implemented. Although the best mode of carrying out the disclosure has been set forth herein, those of ordinary skill in the art would recognize that other embodiments for carrying out or practicing the disclosure are also possible.

It should be noted that the terms "first", "second", and the like, herein do not denote any order, quantity, or importance, but rather are used to distinguish one element from another. Further, the terms "a" and "an" herein do not denote a limitation of quantity, but rather denote the presence of at least one of the referenced item.

As was mentioned above, outdoor use of electronic display screens subjects them to rain, snow, dust, and/or corrosive atmospheres which may cause damage or shorten their life cycle. Known solutions to prevent exposure of display screens to environmental factors include putting the display screen inside a larger box, or an enclosure with bulky, external hinges which are also exposed to the environment and similarly susceptible to negative impacts on functionality and/or durability.

Embodiments of the disclosure provide a case or enclosure which may be suitable for protecting a display screen against access by an unauthorized party and/or damage by contact with foreign particles or other environmental factors.

Embodiments of the disclosure substantially eliminate, or at least partially address, problems in the prior art, enabling internal placement of hinges into an enclosure suitable for preventing environmental exposure to a display screen. Embodiments of the disclosure may be suitable for protecting any of a variety of displays including but not limited to monitors, televisions, tablets, phablets or consoles.

Additional aspects, advantages, features and objects will be made apparent from the drawings and the detailed description of the illustrative embodiments construed in conjunction with the appended claims that follow. It will be appreciated that features of the disclosure are susceptible to being combined in various combinations without departing from the scope of the disclosure as defined by the appended claims.

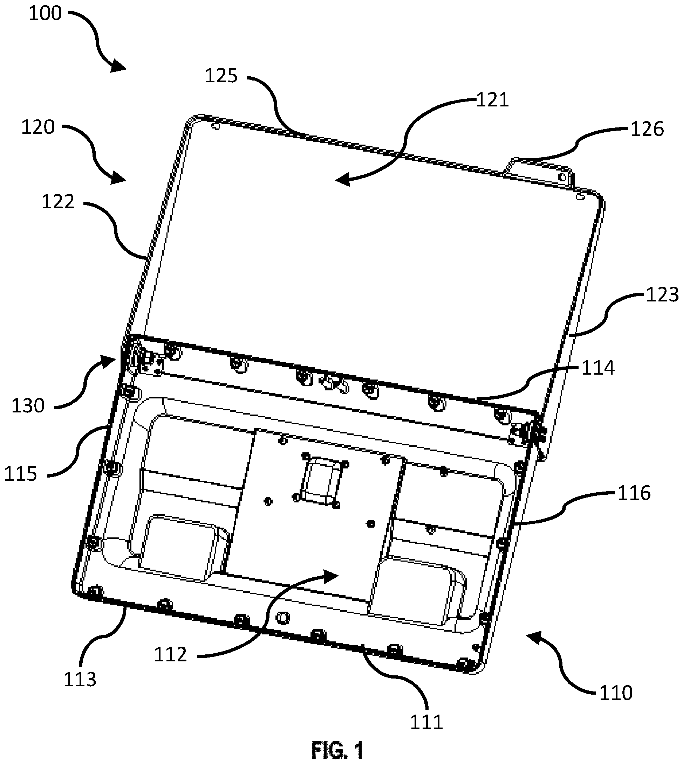

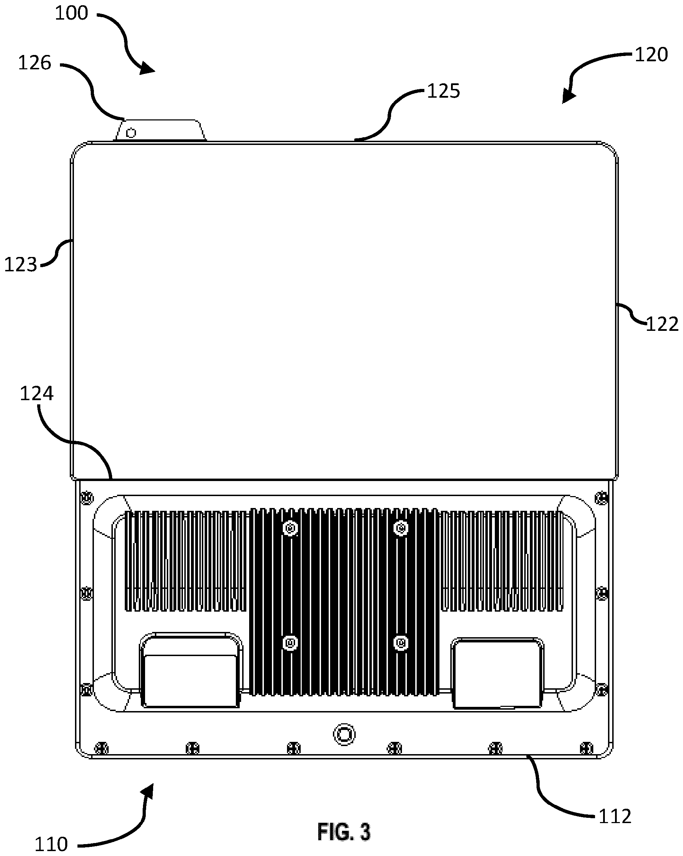

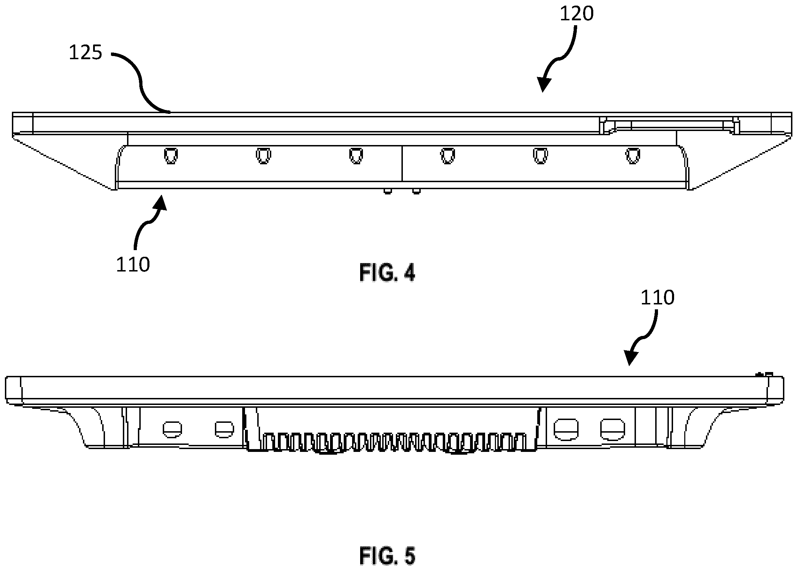

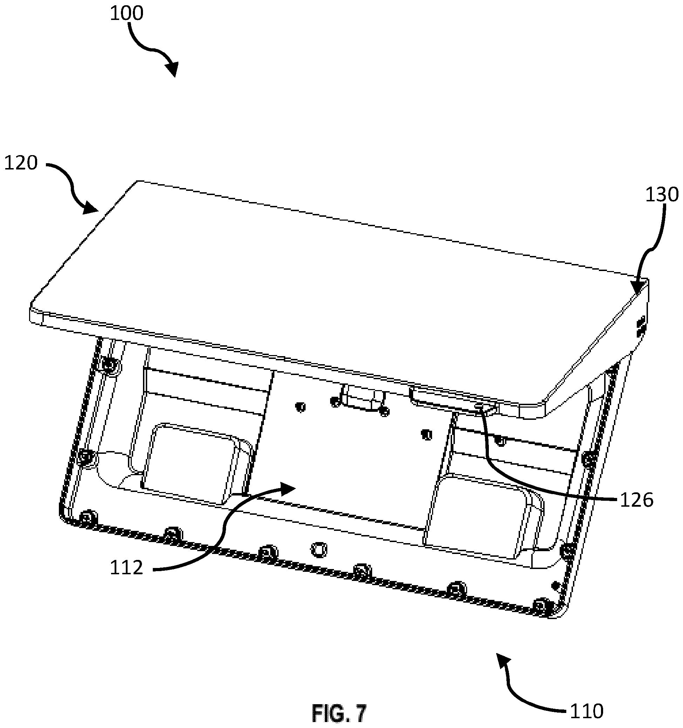

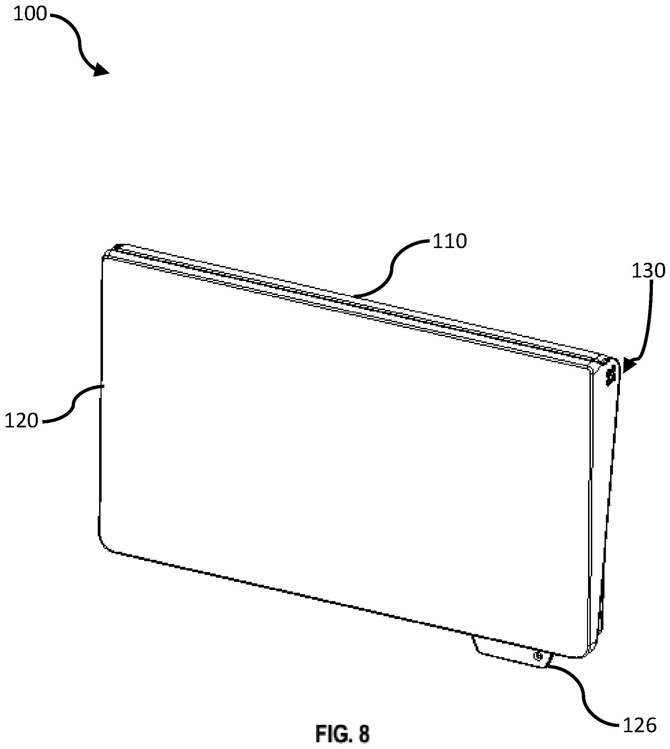

Referring to FIGs. 1-8, example enclosure 100 includes a base shell 110, a lid 120 and at least one hinge 130 coupled between lid 120 and base shell 110 to enable relative pivoting thereof between open and closed states.

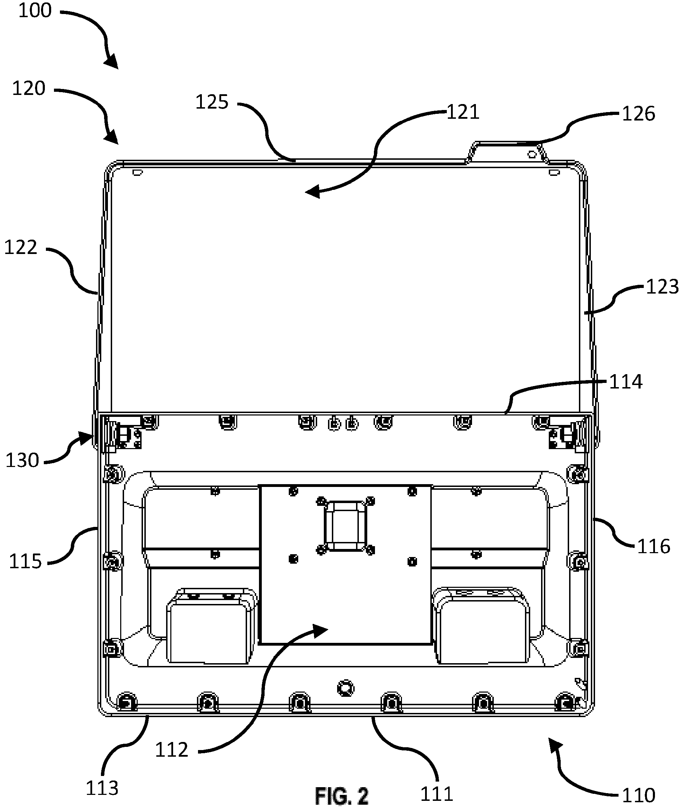

Base shell 110 has a face edge 111 extending forward of a rear wall 112 to define a top side 114, a bottom side 113, a left side 115 and a right side 116 (FIGs. 1 and 2). Lid 120 has a front cover 121 defined between first and second side walls 122 and 123, proximal edge 124 and distal edge 125. A flange or handle 126 and eyelet for a lock may be provided to distal edge 125.

A width between left side 115 and right side 116 of base shell 110 may be less than a width between first and second side walls 122 and 123 of lid 120 to allow internal surfaces of lid side surfaces 122 and 123 pivot on external surfaces of base shell 110 side surfaces 115 and 116.

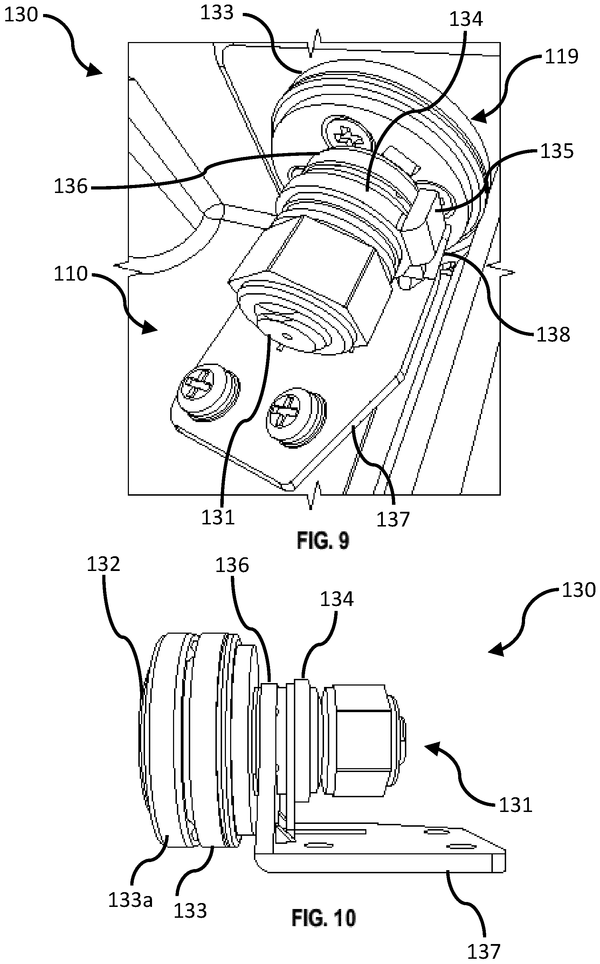

Hinge 130 (FIGs. 9 & 10) may include a knuckle 136 coupled to base shell 110 through a leaf 137 and a pin or shaft 131 coupled to lid 120 and rotatable within knuckle 136. When considered in isolation from the components it couples and in contrast with some hinge types like butt hinges with a pin or shaft and two leaves which each move relative to the shaft, hinge 130 includes a shaft 131 and a single leaf 137 and knuckle 136 and, with no knuckle interlacing, facilitates internal placement. It should be noted that while knuckle 136 and leaf 137 are referred to herein as separate pieces, in many embodiments they are formed from a single piece.

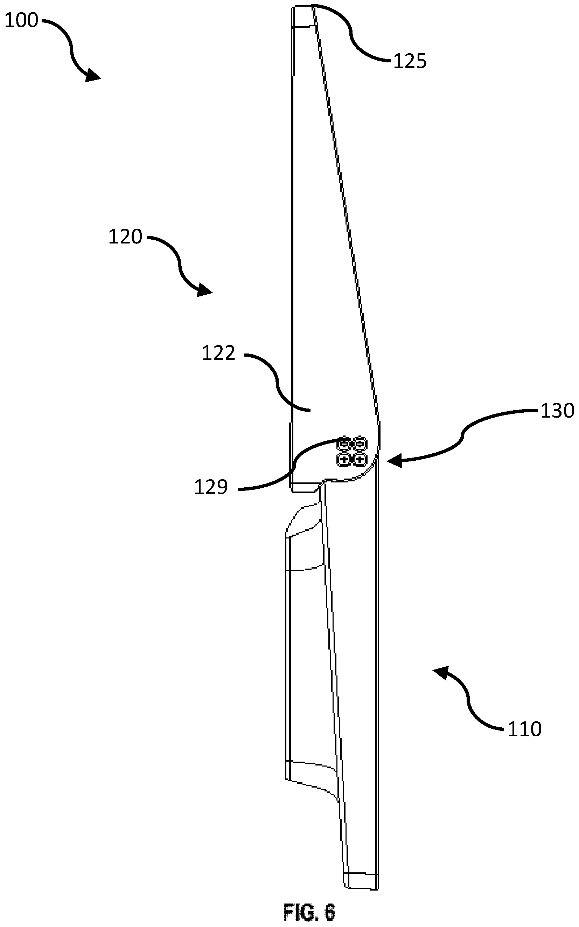

Lid 120 may be fixedly mounted to a head feature 132 of shaft 131 such that relative motion between lid 120 and shaft 131 is prohibited and lid 120 rotates with shaft 131. Side walls 122 and 123 include fastener holes for receiving fasteners 129 (FIG. 6) to couple head 132 of shaft 131 to lid 120. In an example, first side wall 122 of lid 120 may be coupled to shaft 131 such that the longitudinal axis of shaft 131 is approximately normal thereto.

Knuckle 136 may be coupled to base shell 110 through a leaf 137 such that relative motion between base shell 110 and knuckle 136 is prohibited and shaft 131 is distanced from the back wall of base shell 110. In an example, leaf 137 is mounted directly to rear surface 112 of base shell 110 such that face of head 132 of shaft 131 extends generally normal to the mounting surface for leaf 137 at rear surface 112.

Each side surface of base shell 110 is provided with openings 119 (FIG. 9) through which shaft 131 may extend and relative to which shaft 131 may rotate. A first gasket 133 lines each of openings 119 on the interior of the case. A second gasket 133a is inserted from the exterior of the case to line each of openings 119. Together, first gasket 133 and second gasket 133a seal space enclosed by base shell 110 and lid 120 from the environment. Providing gaskets to openings 119 is only an example and similar results may be achieved by providing a gasket to shaft 131 where shaft 131 extends through opening 119. It should be noted that in some embodiments only one of the first gasket 133 and second gasket 133a is provided to seal opening 119.

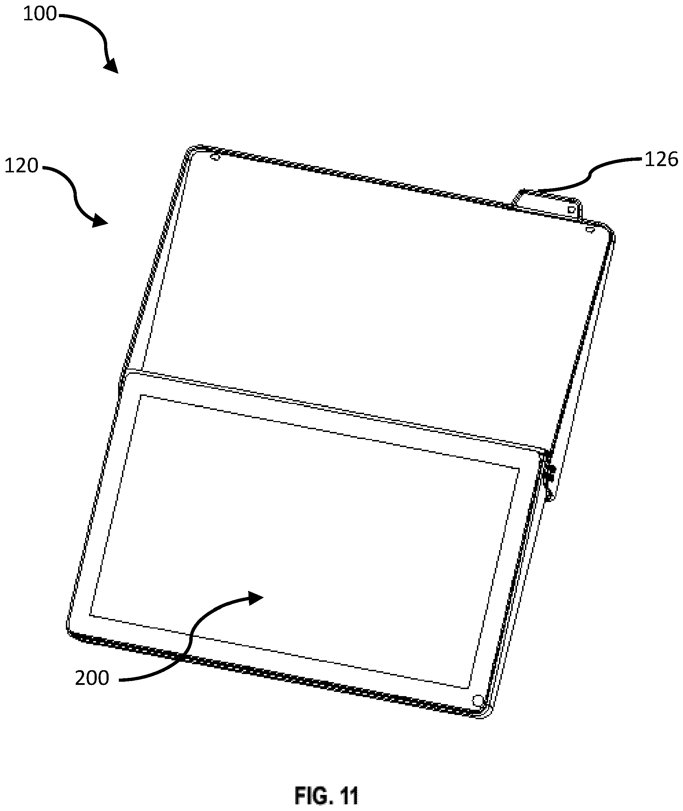

The point of relative motion between knuckle 136 and shaft 131 is internal to both lid 120 and base shell 110. The position of hinge 130 internal to enclosure 100 and the provision of first gasket 133 and second gasket 133a contribute to enclosure 100 being suitable for protecting a display screen 200 (FIG. 11) against access by an unauthorized party and/or damage by contact with foreign particles. For example, enclosure 100 may be IP65-rated to offer complete protection against contact with dust and water jets from any direction.

Hinge 130 may have some features in common with known hinge types including but not limited to barrel hinges, pivot hinges, swivel hinges and lift-off hinges. The simplicity of hinge 130 attributed in part to its inclusion of only two relatively mobile components and potential reduction to a single class of relative motion, enables location of the hinge pivot axis internal to proximal edge 124 of lid 120 and top wall 114 of base shell 110 rather than at or external thereto. The hinge pivot axis may be spaced from all of edges 113, 114, 124 and 125.

The interface of hinge 130, the point of relative motion between the hinge components, is within a space defined by face edge 111, rear wall 112, top side 114, bottom side 113, left side 115 and right side 116 of base shell 110 and is internal to both lid 120 and base shell 110.

To avoid unintentional pivoting, in an example, hinge 130 may offer a torque resisting relative pivoting of lid 120 and base shell 110 to up to a threshold. In one example, the resistance to relative rotation between shaft 131 and knuckle 136 is a frictional force. Any of a variety of techniques may be used to provide a suitable frictional force. In some implementations, the resisting torque offered by hinge 130 can be adjusted.

Because hinge 130 has only a single leaf 137 and no interlaced knuckles, leaf-to-leaf collision does not limit relative rotation of distal ends of hinge 130. However, hinge 130 may nevertheless include features that limit a range of relative pivoting between lid 120 and base shell 110 in at least one direction rather than relying on relative geometry of lid 120 and/or base shell 110. Relative pivoting between lid 120 and base shell 110 may be limited by a tab 135 mounted to shaft 131 by way of a ring 134 and a stationary stop 138 mounted to base shell 110. This may be particularly desirable in the opening direction since, for example, edge 124 of lid 120 may otherwise bind against the exterior surface of rear wall 112 of base shell 110 producing wear. In an example, tab 135 is formed on leaf 137.

While a single hinge 130 has been described in detail above, enclosure 100 may include two or more hinges (FIGs. 1 and 2). For example, a first hinge 130 is coupled between an interior surface of rear wall 112 of base shell 110 and an interior surface of first side wall 122 of lid 120 and a second hinge is coupled between the interior surface of rear wall 112 of base shell 110 and an interior surface of second side wall 123 of lid 120. Lid 120 and base shell 110 together with two hinge components actually form an assembly which may resemble a single large butt hinge with a discontinuous shaft 131.

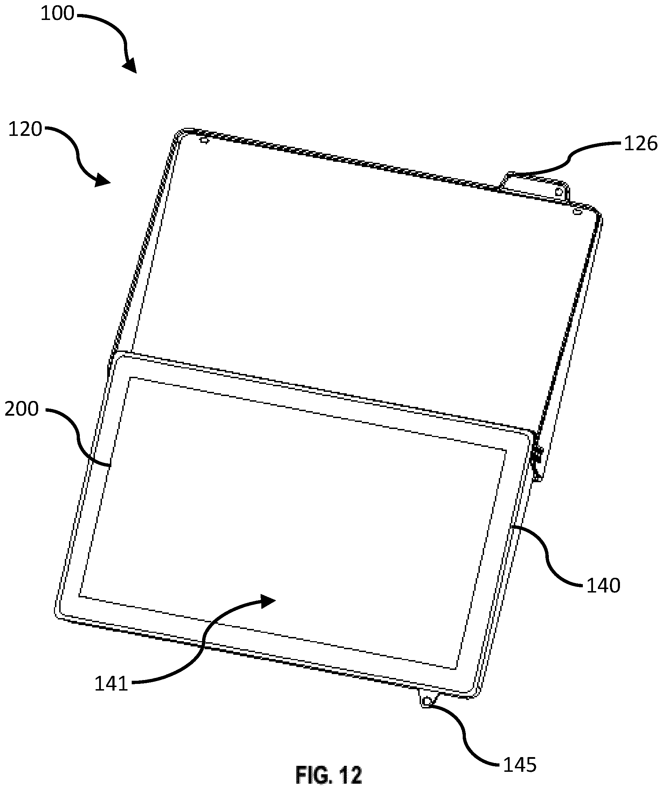

Referring to FIG. 12, enclosure 100 may further include a bezel 140 provided to face edge 111 of base shell 110. Bezel 140 includes a transparent bezel screen 141 and a flange 145 with an eyelet matching eyelet of handle 126.

Disclosed enclosures may be produced, manufactured, constructed or assembled according to any of a variety of methods. One example method includes providing a base shell and coupling at least one hinge between the base shell and a lid to enable relative pivoting thereof.

The base shell may be formed from any of a variety of rigid, durable materials to have a face edge extending forward of a rear wall to define a top side, a bottom side, a left side and a right side. The base shell may be formed into any of a variety of dimensions suitable for enclosing a display screen. An opening may be created through each of the left and right sides to accommodate one or more hinges.

The lid may be formed with a front cover and first and second side walls from one or more materials similar to those of the base shell. The lid may be formed into any of a variety of dimensions suitable for at least partially enclosing a display screen. In an example, the lid is produced with a width slightly greater than the width of the base shell so that the enclosure may be assembled with interior surfaces of the lid first and second sides contacting or nearly contacting exterior surfaces of the base shell left and right sides. A number of openings may be created through each of the lid first and second side walls to accommodate fasteners enabling coupling of the lid to the at least one hinge.

The at least one hinge may be coupled between the base shell and the lid by surrounding a shaft with a knuckle, extending the shaft through the opening created in one or both sides of the base shell and coupling the knuckle to the base shell through a leaf. For example, the leaf may be fastened to an internal surface of the rear wall of the base shell so as to distance the surrounded shaft from the back wall of the base shell and prohibit relative motion between the base shell and the knuckle. Fastening of the leaf or leaves to the base shell may be accomplished with any of a number of means including but not limited to screws or welds.

Fasteners are inserted through a number of openings in the lid first side wall and into threaded bore holes in a head of the shaft to fixedly mount the lid thereto such that relative motion between the lid and the shaft is prohibited. The shaft may be coupled to the lid with a longitudinal axis of the shaft approximately normal to the side surfaces of the lid. The hinge may be coupled between the base shell and the lid so that the pivot axis is distal from parallel or aligned edges of the base shell and parallel or aligned edges of the lid.

By providing the knuckle within the base shell, the interface between components of the hinge is within a space defined by the face edge, the rear wall, the top side, the bottom side, the left side and the right side of the base shell and shielded from environmental factors. Before extending the shaft through the opening in the side wall of the base shell, the opening may be lined with a gasket configured with an internal diameter matching an external diameter of the shaft with a sufficiently narrow tolerance to prevent ingress of foreign particles such as moisture and/or debris. For example, the IP65 standard may be supported by the cooperation of the shaft, opening and gasket.

A resistive torque may be provided to the hinge to resist relative pivoting of the lid and base shell due to small, unintentional or undesirable forces such as gravity. In one example, sandwiched discs may be fixedly mounted to each of the shaft and the knuckle and the frictional force provided will be proportional to the pressure between the discs in response to tightening a nut against the disks. In another example, the resisting torque is provided by a frictional force between the exterior surfaces of the shaft and interior surfaces of the knuckle.

The hinge may be so formed as to limit the range of relative pivoting between the lid and the base shell rather than pivoting being limited by geometry of the lid and/or base shell. A stationary stop or projection may be formed on the knuckle or leaf for engagement by a tab formed on a disc mounted to a shaft.

With a first hinge installed between a first side wall of the lid and the base shell, a second hinge may be installed between a second wall of the lid and the base shell in a manner similar to the first hinge. A second shaft mounted to lid will rotate relative to a second knuckle fixed to the base shell rear wall.

The method may further include providing a bezel to the face edge of the base shell. If the bezel has been provided to the face edge without a display screen held in the enclosure, the bezel will need to be removed before providing the display screen.

Disclosed enclosures and/or methods for producing the enclosures are suitable for use in association with any of a variety of methods for enclosing a display screen. One example method includes providing a base shell, a lid and at least one hinge coupled between the lid and the base shell. The base shell includes a face edge extending forward of a rear wall to define a top side, a bottom side, a left side and a right side while the lid has a front cover and first and second side walls. The first and second side walls of the lid may overlap the left side and the right side of the base shell.

With the lid pivoted into a completely open position away from the base shell, a display screen is placed into the base shell within the space defined by the face edge, the rear wall, the top side, the bottom side, the left side and the right side of the base shell. To frame and stabilize the display screen, a bezel is mated with the face edge of the base shell and fastened in place.

The base shell and the lid may then be relatively pivoted between open, intermediate and closed states by rotating, within knuckles coupled to the base shell, shafts coupled to the lid such that longitudinal axes of the shafts extend approximately normal to the side surfaces of the lid. In an example, the lid is pivoted relative to the base shell by grasping and lifting or pulling a handle provided to the lid distal from the pivot axis. To open the lid completely, the handle is rotated around the pivot axis to a position 180 degrees away from the closed position. The interface between the shaft and the knuckle is at least partially enclosed within a space defined by the face edge, the rear wall, the top side, the bottom side, the left side and the right side of the base shell. The shaft may be rotated while preventing ingress of foreign particles by rotating the shaft within a gasket-lined opening in one of the left side and right side of the base shell.

Relatively pivoting the base shell may be resisted by a torque offered by the hinge which encourages the pivot angle between the lid and the base shell to be maintained against small rotational forces such as that imposed by gravity. Further, the resistive torque limits the speed with which relative pivoting may be accomplished.

When relatively pivoting the base shell and the lid, the range may be limited by the hinge in one or both directions. The lid may pivot relative to the base shell until a stationary stop mounted to the base shell is engaged by a tab mounted to the shaft at which point relative pivoting between the lid and the base shell is arrested.

With the lid pivoted against the bezel and and/or the face edge of the base shell and an eyelet formed through a handle on the distal edge of the lid aligned with an eyelet formed through a flange provided to the bezel, a lock may be inserted through the aligned eyelets to lock the lid in the closed position.

Embodiments of the disclosure are susceptible to being used for various purposes, including, though not limited to, enabling users to safely house a display screen in an outdoor environment while preventing damage to the display screen from damage present in the environment. An internally placed hinge enables the display screen to be housed by relatively pivoting components while avoiding environmental exposure to the hinge. Internal placement of the hinge also provides a sleeker and more attractive overall look when compared with bulky exterior hinges.

Modifications to embodiments of the disclosure described in the foregoing are possible without departing from the scope of the disclosure as defined by the accompanying claims. Expressions such as "including", "comprising", "incorporating", "consisting of", "have", "is" used to describe and claim the disclosure are intended to be construed in a non-exclusive manner, namely allowing for items, components or elements not explicitly described also to be present. Reference to the singular is also to be construed to relate to the plural.

## Claims

1. An enclosure (100) for a display screen (200), comprising:
a base shell (110) having a face edge (111) extending forward of a rear wall (112) to define a top side (114), a bottom side (113), a left side (115) and a right side (116);
a lid (120) having a front cover (121) and first and second side walls (122, 123); and
at least one hinge (130) coupled between the lid (120) and the base shell (110) to enable relative pivoting thereof between open and closed states such that an interface of the hinge (130) is within a space defined by the face edge (111), the rear wall (112), the top side (114), the bottom side (113), the left side (115), and the right side (116) of the base shell (110), wherein the at least one hinge (130) further comprises:
a knuckle (136) coupled to the base shell (110) through a leaf (137); and
a shaft (131) rotatable within the knuckle (136) and coupled to the lid (120), and
wherein the first and second side walls (122, 123) of the lid (120) overlaps the left side (115) and the right side (116) of the base shell (110).

2. The enclosure (100) according to claim 1, wherein the hinge (130) offers a torque resisting relative pivoting of the lid (120) and base shell (110).

3. The enclosure (100) according to claim 1 or 2, wherein the hinge (130) limits a range of relative pivoting between the lid (120) and the base shell (110) in at least one direction, wherein relative pivoting between the lid (120) and the base shell (110) is limited by a tab (135) mounted to the shaft (131) and a stationary stop (138) mounted to the base shell (110).

4. The enclosure (100) according to any one of claims 1-3, further comprising a bezel (140) provided to the face edge (111) of the base shell (110).

5. The enclosure (100) according to any one of claims 1-4, wherein the at least one hinge (130) further comprises a first hinge (130) coupled between an interior surface of the rear wall (112) of the base shell (110) and an interior surface of the first side wall (122) of the lid (120) and a second hinge coupled between the interior surface of the rear wall (112) of the base shell (110) and an interior surface of the second side wall (123) of the lid (120).

6. The enclosure (100) according to claim 1, wherein the lid (120) is fixedly mounted to the shaft (131).

7. The enclosure (100) according to claim 1 or 6, further comprising a gasket (133) surrounding the shaft (131).

8. The enclosure according to claim 1 or any one of claims 6-7, wherein the shaft (131) extends through an opening (119) in the one of the left side (115) and right side (116) of the base shell (110).
